# EUROPÄISCHE PATENTANMELDUNG

(11) **EP 0 607 844 A1**
(43) Veröffentlichungstag der Anmeldung: **27.07.1994**
(21) Anmeldenummer: 94100304.8
(22) Anmeldetag: 11.01.1994
(51) Int. Cl.: H05K 7/02

(54) **Einstückiges Isolierteil, insbesondere Spritzgiessteil**

(30) Priorität: 22.01.1993 DE 9300867 U
(71) Anmelder: SIEMENS AKTIENGESELLSCHAFT, D-80333 München (DE)
(72) Erfinder: Schönberger, Eduard, Dipl.-Ing. (FH), D-92245 Kümmersbruck (DE); Kasowski, Hermann, Dipl.-Ing. (FH), D-92280 Kastl (DE); Gruber, Stefan, Dipl.-Ing. (FH), D-92245 Kümmersbruck (DE); Schmidt, Heinz, Dipl.-Ing. (FH), D-92245 Kümmersbruck (DE)

(57) **Zusammenfassung**

Spritzgießteile (1) mit integrierten Leiterzügen (16) sind bekannt. Erfindungsgemäß wird ein derartiges Spritzgießteil (1) in mindestens zwei Bestückebenen (2 bis 8, 20 bis 22) mit elektrischen und/oder elektronischen Bauelementen (9 bis 15, 23 bis 25) bestückt. Die Bestückebenen (2 bis 8, 20 bis 22) können dabei sowohl übereinander als auch in einem Winkel zueinander angeordnet sein. Mit dem erfindungsgemäßen Spritzgießteil (1) wird eine bessere Volumenausnutzung der Gesamtschaltung erreicht.

## Beschreibung

Die vorliegende Erfindung betrifft ein einstückiges Isolierteil, z. B. ein Kunststoffteil, insbesondere ein Spritzgießteil, mit auf dem Isolierteil angeordneten Leiterzügen. Ein derartiges Isolierteil ist beispielsweise aus der EP-0 465 692 A1 bekannt. Auch beim Automatisierungsgerät SIMATIC S5-95 U der Siemens AG wird ein derartiges Isolierteil als Gehäuserückwand verwendet.

Die bisher bekannten Spritzgießteile mit Leiterzügen waren selbst meist unbestückt, wurden z. B. nur als Rückwandbus verwendet. Übliche Leiterplatten dagegen sind flächig ausgebildet, können also höchstens auf ihrer Vorder- und ihrer Rückseite bestückt werden. Beim Aufbau der Schaltung bleibt daher ein relativ großes Volumen ungenutzt. Die Schaltungen sind also relativ groß.

Die Aufgabe der vorliegenden Erfindung besteht darin, die Volumenausnutzung zu vergrößern, so daß im Ergebnis kleinere Schaltungen, z. B. kleinere Steuerungen, realisiert werden können.

Die Aufgabe wird dadurch gelöst, daß auf dem Isolierteil in mindestens zwei Bestückebenen elektrische und/oder elektronische Bauelemente anordenbar sind, die über die auf dem Isolierteil angeordneten Leiterzüge elektrisch leitend verbunden sind.

Durch die Verwendung eines dreidimensionalen Isolierteils werden darüber hinaus zusätzliche Topologiefreiheitsgrade ermöglicht, so daß einfachere Leitungsführungen als bei Leiterplatten möglich sind.

Weitere Vorteile und Einzelheiten ergeben sich aus der nachfolgenden Beschreibung eines Ausführungsbeispiels, anhand der Zeichnungen und in Verbindung mit den Unteransprüchen. Dabei zeigen:
- FIG 1: ein erfindungsgemäßes Spritzgießteil in perspektivischer Darstellung und
- FIG 2: ein Detail eines Spritzgießteils.

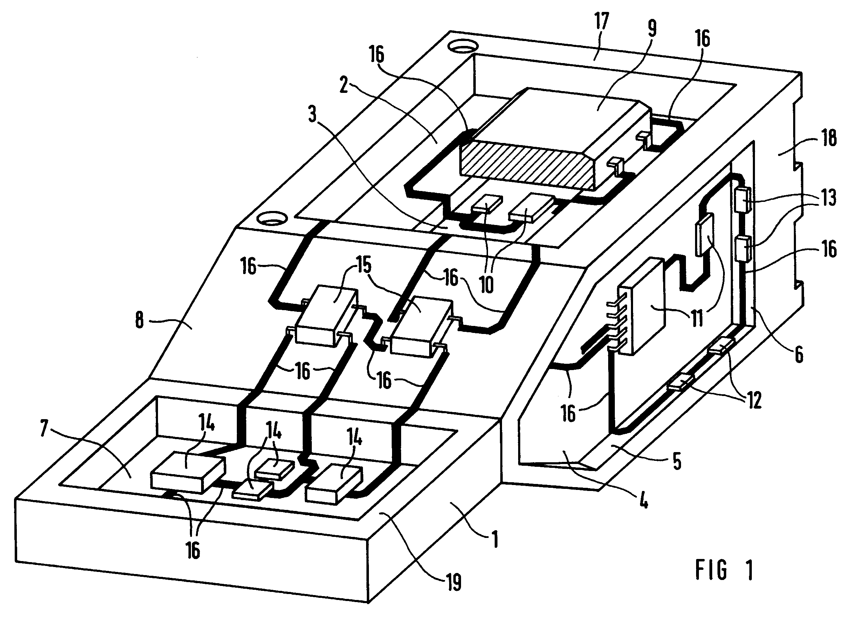

Gemäß FIG 1 weist das Spritzgießteil 1 eine Vielzahl von Bestückebenen 2 bis 8 auf. In den Bestückebenen 2 bis 8 sind Bauelemente 9 bis 15, z. B. ICs, Widerstände, Dioden oder Relais, angeordnet, die über Leiterzüge 16 elektrisch leitend miteinander verbunden sind. Sowohl die Herstellung des Spritzgießteils als auch das Aufbringen der Leiterzüge 16 als auch das Bestücken eines Schaltungsträgers mit Bauelementen 9 bis 15 erfolgt dabei in an sich bekannter Weise.

Wie aus FIG 1 ersichtlich ist, können die Bestückebenen sehr frei angeordnet werden. Beispielsweise sind die Bestückebenen 2 und 3 übereinander angeordnet. Die Bestückebene 4 dagegen ist im Winkel von 90° zu allen anderen Bestückebenen 2, 3, 5 bis 8 angeordnet.

Zum Schutz der Bauelemente 9 bis 14 vor Beschädigung sind die Bestückebenen 2 bis 7 versenkt, also im Inneren des Kunststoffteils 1 angeordnet. Die Bestückebenen 2 bis 7 sind dabei soweit in das Spritzgießteil 1 hineinversenkt, daß die höchsten der Bauelemente 9 bis 14 die Begrenzungsebenen 17 bis 19 nicht überragen.

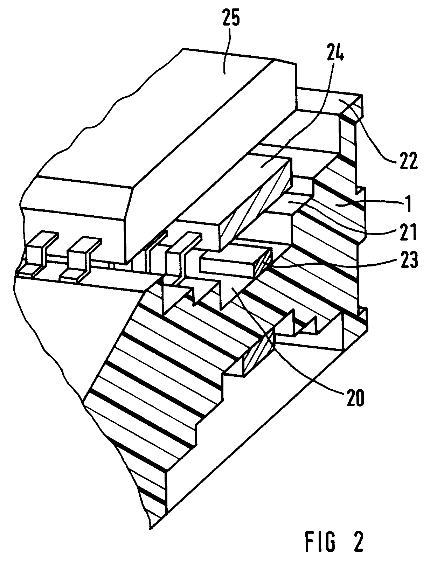

Gemäß FIG 2 können nicht nur zwei, sondern auch drei und mehr Bestückebenen 20 bis 22 übereinander angeordnet werden. In diesem Fall sind selbstverständlich auch drei Schichten von Bauelementen 23 bis 25 vorhanden.

Anstelle eines Spritzgießteils kann auch ein anderer einstückiger, auf seiner Oberfläche zunächst elektrisch isolierender Schaltungsträger verwendet werden, z. B. ein auf seiner gesamten Oberfläche in geeigneter Weise eloxiertes Aluminium-Druckgußteil.

## Patentansprüche

1. Einstückiges Isolierteil, z. B. Kunststoffteil (1), insbesondere Spritzgießteil (1), mit auf dem Isolierteil (1) angeordneten elektrischen und/oder elektronischen Bauelementen (9 bis 15, 23 bis 25), wobei die Bauelemente (9 bis 15, 23 bis 25) über auf dem Isolierteil (1) angeordnete Leiterzüge (16) elektrisch leitend verbunden sind, **dadurch gekennzeichnet,** daß die Bauelemente (9 bis 15, 23 bis 25) in mindestens zwei Bestückebenen (2 bis 8, 20 bis 22) anordenbar sind.

2. Isolierteil nach Anspruch 1, **dadurch gekennzeichnet,** daß die zwei Bestückebenen (z.B. 2,3) übereinander angeordnet sind.

3. Isolierteil nach Anspruch 1 oder 2, **dadurch gekennzeichnet,** daß die zwei Bestückebenen (z.B. 2,4) in einem Winkel, z. B. von 90°, zueinander angeordnet sind.

4. Isolierteil nach Anspruch 1, 2 oder 3, **dadurch gekennzeichnet,** daß die Bestückebenen (z.B. 2 bis 7) versenkt angeordnet sind.

5. Isolierteil nach einem der obigen Ansprüche, **dadurch gekennzeichnet,** daß es als mit einer Isolierschicht versehenes Metallteil, z. B. als eloxiertes Aluminium-Druckgußteil, ausgebildet ist.
